Europäisches Patentamt

European Patent Office

Office européen des brevets

(19)

(11) Publication number: **0 175 515**
**A1**

## (12) EUROPEAN PATENT APPLICATION

(21) Application number: **85306229.7**

(22) Date of filing: **03.09.85**

(51) Int. Cl.⁴: **G 01 R 23/15**

(30) Priority: **05.09.84 GB 8422369**

(43) Date of publication of application: **26.03.86**
**Bulletin 86/13**

(84) Designated Contracting States: **AT BE CH DE FR IT LI NL SE**

(71) Applicant: **WESTINGHOUSE BRAKE AND SIGNAL COMPANY LIMITED, Pew Hill, Chippenham Wiltshire (GB)**

(72) Inventor: **Badge, Roger, 84 Eastfield Road Westbury-on-Trym, Bristol (GB)**
Inventor: **Pilkington, Simon David John, 33 Pennine Road Oldland Common, Bristol (GB)**

(74) Representative: **Bird, Vivian John et al, PAGE & CO. Temple Gate House, Temple Gate Bristol, BS1 6PL (GB)**

(54) **Low distortion limiter circuit.**

(57) In the receiver of a railway track circuit signal detector an input stage is connected before an anti-alias filter and a digital sampling stage which supplies time-series data samples to a fast Fournier transform processor. The input stage comprises a tuned amplifier stage which «rings» at the track circuit frequency when stimulated by a track circuit signal in the input. The stage acts as a non-limiting, linear amplifier at other frequencies and as a non-linear, limiting amplifier at the track circuit frequency and provides, when stimulated, a virtually pure sinewave output. Since the range of amplitudes is more compressed as a result, more efficient use can be made of the available digital range and of the transform processor.

- 1 -

## Low distortion limiter circuit

The invention relates to an arrangement for determining the presence or absence of a signal frequency, and especially to a low distortion limiter circuit for use with a frequency analyser adapted to identify said signal frequency.

In one form of the invention the frequency analyser including the low distortion limiter circuit of the present invention is useful for detecting the presence of the predetermined frequency of a railway track circuit receiver.

The background of the invention involves the use of audio frequency signals carried by continuously welded track to determine the location of a train on the track. In continuously welded track the track signals are confined within sections by tuning units or impedance bonds. For the greater part these units effectively confine the track signals within individual track sections but, faults and varying ambient electrical conditions, (e.g. track ballast resistance, shunt capacitance etc) can give rise to significant levels of cross-talk and unchecked propagation. It is necessary therefore to apply some form of discrimination in track circuit receivers to maintain a high level of receiver integrity and usage in widely varying conditions.

Digital techniques are currently being developed to detect track circuit signals, one such type of apparatus employs a frequency spectrum analyser in the track circuit receiver. The basic requirement of a receiver is to determine whether or not the track circuit characteristic frequency, as sent by its associated track circuit transmitter, is present. A track circuit receiver therefore has to determine

0175515

- 2 -

whether a received signal possesses the expected frequency characteristics and to determine whether it is present at a sufficient level to reliably indicate an unoccupied track section.

According to the present invention an arrangement for determining the presence or absence in an electrical input of a signal having a predetermined frequency comprises an input path connected to an amplifier stage having a tuned load arranged to ring at said predetermined frequency, the output of said amplifier stage being connected to means responsive to said predetermined frequency to provide an indication that a signal having said frequency is present in the input.

The frequency analyser may comprise digital processing means and the limiter circuit is coupled to the input of an analogue-to-digital converter and wherein the maximum voltage excursion of the limiter is restricted to a level slightly below the maximum input level of the converter.

In one form of the invention the arrangement referred to is connected in a railway jointless track circuit receiver.

One form of the invention and how it may be carried into practice will now be described, by way of example only, with reference to the accompanying drawings, in which:

Fig. 1 shows a block diagram of a jointless track circuit receiver employing a digital frequency analyser, and

Fig. 2 shows a circuit diagram of a low distortion

- 3 -

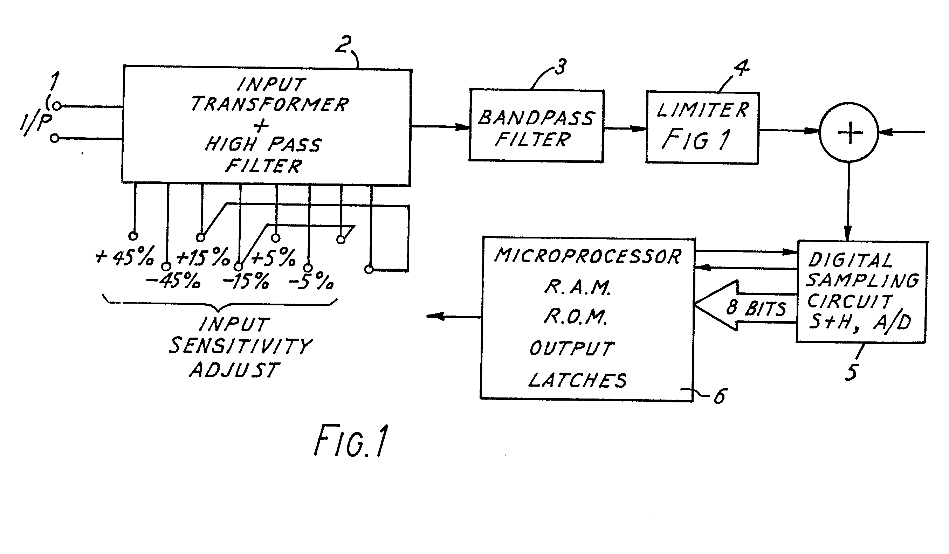

limiter circuit employed in the arrangement of Fig. 1.

Referring now to Fig. 1 there is shown a portion of the input path of a railway jointless track circuit receiver, in block diagram form, from which incidental parts of the arrangement not directly concerning the invention have been omitted for the sake of brevity and clarity.

The receiver has a pair of signal input terminals 1, which in practice are connected to the secondary winding terminals of an inductance in a tuned impedance bond mounted in the four-foot, that is in the bed of the railway track (not shown). The input terminals connect with the input winding of a transformer 2 having a series of alternatively selectable output windings which may be chosen to provide the required level of receiver input sensitivity.

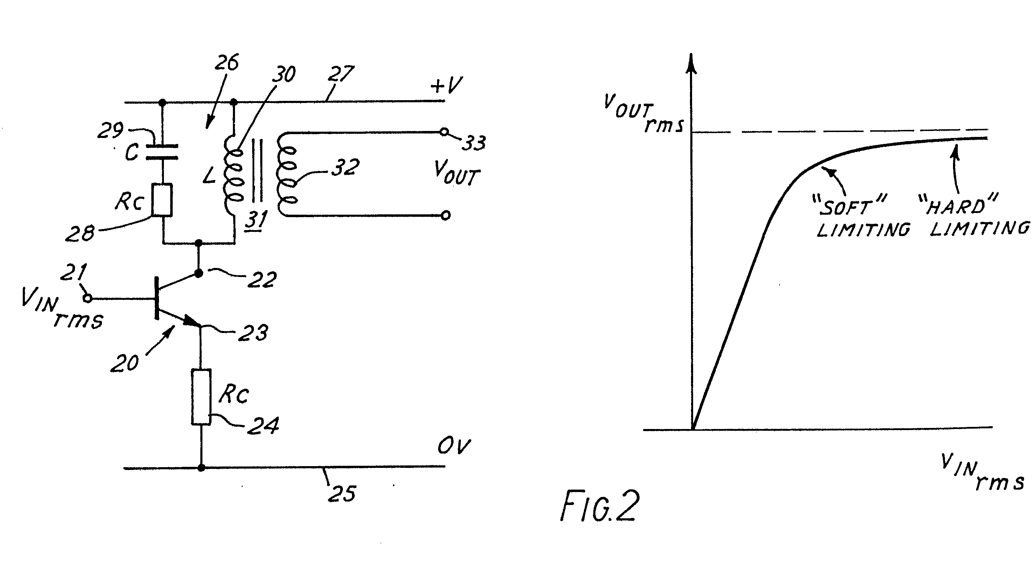

The receiver input path continues from an output winding of transformer 2 through a linear phase bandpass filter 3 to a low distortion limiter circuit, generally indicated at block 4 and shown in more detail in Fig. 2. From limiter 4 the signal path passes to the input of a sample and hold circuit followed by an 8 bit analogue to digital converter 5.

The digital output of the circuit 5 is operatively connected to the input of a microprocessor, generally indicated at 6, which is suitably programmed to perform a frequency spectrum analysis function, e.g. by the implementation of a discrete or fast Fourier transform algorithm. The output of the microprocessor 6 is adapted to indicate the state of occupancy of the track circuit section by a railway vehicle in a fail-safe manner. If the track circuit signal is

- 4 -

detected then the section is unoccupied. The processor output is coupled to, for example, a conventional track occupancy relay (not shown).

When a track section is unoccupied the section rails behave as a transmission line with series inductance and resistance, and shunt capacitance and resistance. Under some ambient conditions the shunt resistance, broadly determined by the electrical characteristics of track ballast, may be relatively low, and therefore, although the signal arriving at the receiver is reduced there remains in virtually all operating conditions a sufficient signal level for positive identification. This signal level is represented by a minimum input signal voltage level in the receiver and any input signal having a voltage level greater than this may be termed a GO state.

When the track section is occupied, i.e. there is at least one vehicle axle effectively shorting the rails together, the transmitter signal is prevented from reaching the receiver input. Although, under practical conditions, a certain level of signal still reaches the receiver it is signficantly lower than the minimum level in an unoccupied track circuit, and this represents a maximum "NO-GO" signal level. For reliability sake a hysteresis factor is provided in the discrimination of these levels, providing a voltage band between the occupied and unoccupied voltage levels.

In operation the track circuit receiver is continually searching to locate and positively identify the characteristic track circuit signal propagated through the track rails by the associated track circuit transmitter. A positive identification of this signal, i.e. of carrier level above a fixed

0175515

- 5 -

threshold, by the receiver is accepted as proof of the unoccupied state of the track section between the transmitter and receiver. The threshold discrimination function is applied to the output from the microprocessor, it forms one part of the present invention and corresponding means for carrying out this function are not shown in the drawings. A signal coupled from the impedance bond, connected between the rails in the four-foot, passes by means of input transformer 2 to the input of bandpass filter 3 which confines the frequency spectrum of the received signal within predetermined frequency limits, and the band limited received signal is passed on to the limiter circuit 4.

In the example being described the analogue to digital converter circuit 5, as previously mentioned, provides an 8 bit digital representation of an analogue input signal sample. The problem that arises stems from the relatively large range of signal levels which may be present at the input of a track circuit receiver in an unoccupied state. On the one hand, the converter 5 may be scaled to accept the largest possible received signal level within its normal operating range, but the voltage step inherent in each digitised level is so large as to make identification of an occupied state and the hysteresis band unreliable. On the other hand, selection of a sufficiently small voltage step between each digital level, to achieve adequate level discrimination, will in some operating circumstances result in a saturation condition arising. When this occurs the digital converter overflows and the excessively large signal may be represented, not by the largest 8 bit digital number, but by a smaller digital number representing only the excess signal voltage above the maximum level. In these circumstances an unoccupied track condition may be interpreted as an indication of an occupied state.

The limiter circuit 4, with which the present invention is concerned is intended to provide a remedy for this problem by limiting the maximum signal level which can be supplied to the analogue digital converter 5 to a level greater than the minimum signal level provided by an unoccupied track circuit but less than the maximum level of the converter. This limitation to a maximum signal level by the described circuit does not introduce extraneous or intermodulation frequencies, for example due to signal clipping, because of the ringing of the tuned circuit when the track circuit signal frequency is present. The effect of the limiting circuit 4 is to direct the dynamic range of the analogue to digital converter 5 to the range of signal levels of primary interest to the receiver.

A circuit diagram of the limiting circuit 4 is shown in greater detail in Fig 2. This circuit comprises an amplifying transistor 20, in this instance of the NPN type, having base, collector and emitter electrodes 21, 22 and 23 respectively. The base electrode 21 forms the input terminal of the limiting circuit and is conncted to the output of the bandpass filter 3 in Fig 1. A negative feedback resistor 24 is connected between the emitter electrode 23 and a source of reference potential, i.e. the zero volt line 25. A tuned output stage, generally indicated at 26, is connected between the collector electrode 22 and a source of bias potential on line 27. The tuned circuit 26 comprises two branches, a first having a resistor 28 and a capacitor 29 in series, and a second branch formed by the primary winding 30 of an output transformer 31. The output of the limiting circuit being taken from the secondary winding 32 via output terminals 33 and passed to the input of the analogue to digital converter 5 of Fig. 1.

The value of the two resistors 24 and 28 are chosen such that, at resonance, the transistor amplifier stage has a resulting gain of the order of one. The values of capacitance 29 and the input inductance of transformer 31 are selected to resonate at the basic characteristic frequency of the track circuit carrier signal of particular interest. Therefore, when the track circuit carrier frequency is not present in the input signal in any significant proportion, the transistor stage acts as a linear amplifier having extremely low gain. When the characteristic frequency is present in sufficient voltage for limiting the tuned circuit 26 is stimulated and commences "ringing" at the characteristic frequency.

In the ringing condition the voltage at the collector electrode 22 attains maximum excursion and at each alternate half cycle the transistor 20 is "cut-off" for the period during which the forward bias potential of the transistor is cancelled. The effect of this is self regulation of the energy available to the tuned circuit which thereby imposes a natural limit upon the maximum excursion of the output voltage appearing across the terminals 33 of the secondary winding 32. In these circumstances because this output voltage is due purely to the ringing of the tuned circuit the signal is substantially pure sinewave and contains virtually no distortion frequencies. By suitable selection of component values etc. this maximum output voltage excursion is compatible with the maximum required input voltage

0175515

- 8 -

.excursion for the analogue to digital converter 5.

The circuit can also operate linearly as a standard 'tuned collector load' amplifier when the input signal is below that level required for limiting. In view of the application of the circuit it is essential that it shall have "safe" characteristics and to this end it is preferred that the resistors 24 and 28 shall be of the type which cannot decrease in resistance value. Thus, if resistor 24 suffers a fault and its value increases the proportion of feedback increases as a consequence and the gain of the circuit is reduced. If resistor 28 suffers a similar fault then the Q-factor of the tuned circuit (which has a conventional value) decreases so that at resonance the circuit output is effectively damped. Furthermore, because the value of resistances in this circuit cannot decrease, the overall gain of the amplifier cannot increase eliminating the possibility that a residual frequency component in an occupied signal could possibly be boosted to such an extent as to reproduce an unoccupied section indication.

0175515

- 9 -

<u>Claims</u>

1. An arrangement for determining the presence or absence in an electrical input of a signal having a predetermined frequency comprises an input path connected to an amplifier stage having a tuned load arranged to ring at said predetermined frequency, the output of said amplifier stage being connected to means responsive to said predetermined frequency to provide an indication that a signal having said frequency is present in the input.

2. An arrangement according to Claim 1 wherein the amplifier stage comprises a transistor amplifier having a tuned collector load.

3. An arrangement according to Claim 2 connected wherein the tuned collector load comprises a capacitor and in parallel therewith a primary winding of a signal output transformer.

4. An arrangement according to any preceding claim wherein the output of the amplifier stage is coupled to the input sampling circuit of an analogue to digital converter.

5. An arrangement according to Claim 4 wherein the amplifier stage is arranged to provide a ringing output having an amplitude slightly less than the maximum input level of the analogue to digital converter.

6. An arrangement according to any preceding claim connected in a railway track circuit apparatus wherein, in use, the electrical input consists of a received track circuit signal, the predetermined signal frequency is the track circuit signal frequency and the indication given that a signal having said

0175515

- 10 -

frequency is present in the input is adapted to indicate the state of occupancy of the track circuit section by a railway vehicle.

7. An arrangement substantially as described with reference to and as illustrated by the accompanying drawings.

FIG.1

FIG.2

# 0175515

European Patent Office

## EUROPEAN SEARCH REPORT

Application number

## DOCUMENTS CONSIDERED TO BE RELEVANT

EP 85306229.7

| Category | Citation of document with indication, where appropriate, of relevant passages | Relevant to claim | CLASSIFICATION OF THE APPLICATION (Int. Cl.4) |
|---|---|---|---|
| X | US - A - 3 955 148 (MIURA) | 1-3 | G 01 R 23/15 |
| A | * Fig. 1 * | 4-7 | |
| | -- | | |
| X | OTTO LIMANN "Funktechnik ohne Ballast", 13. Auflage, 1975 | 1-3 | |
| A | FRANZIS-VERLAG, München | 4-7 | |
| | * Page 187, fig. 10.27 * | | |
| | ---- | | |

| TECHNICAL FIELDS SEARCHED (Int. Cl.4) |
|---|
| B 61 L 1/00 |
| B 61 L 23/00 |
| G 01 R 23/00 |
| H 03 F 3/00 |
| H 03 G 3/00 |

The present search report has been drawn up for all claims

| Place of search VIENNA | Date of completion of the search 19-12-1985 | Examiner KUNZE |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

PO Form 1503 03 82